# EUROPÄISCHE PATENTSCHRIFT

(11) **EP 1 153 439 B1**
(45) Veröffentlichungstag und Bekanntmachung des Hinweises auf die Patenterteilung: **03.09.2008**
(21) Anmeldenummer: 00972800.7
(22) Anmeldetag: 18.10.2000
(51) Int. Cl.: H01L 31/032, H01L 31/0336, H01L 31/072

(54) **Diodenstruktur, insbesondere für Dünnfilmsolarzellen**
Diode structure, especially for thin film solar cells
Structure à diodes, notamment destinée à des cellules solaires à couches minces

(30) Priorität: 25.11.1999 DE 19956735
(43) Veröffentlichungstag der Anmeldung: 14.11.2001
(73) Patentinhaber: Shell Erneuerbare Energien GmbH, 22335 Hamburg (DE)
(72) Erfinder: KARG, Franz, 80689 München (DE)
(74) Vertreter: Zeestraten, Albertus W. J.
(86) Internationale Anmeldenummer: PCT/EP2000/010265
(87) Internationale Veröffentlichungsnummer: WO 2001/039277

(56) Entgegenhaltungen:
- US-A- 4 703 131
- US-A- 5 626 688
- US-A- 5 676 766
- MD MOSADDEQ-UR-RAHMAN ET AL: "NOVEL LOW-COST SOLID-STATE HETEROJUNCTION SOLAR CELL BASED ON TIO2 AND ITS MODIFICATION FOR IMPROVED EFFICIENCY" JAPANESE JOURNAL OF APPLIED PHYSICS,JP,PUBLICATION OFFICE JAPANESE JOURNAL OF APPLIED PHYSICS. TOKYO, Bd. 35, Nr. 6A, 1. Juni 1996 (1996-06-01), Seiten 3334-3342, XP000735503 ISSN: 0021-4922
- KRISHNA K M ET AL: "Investigation of solid state Pb doped TiO2 solar cell" SOLAR ENERGY MATERIALS AND SOLAR CELLS,NL,ELSEVIER SCIENCE PUBLISHERS, AMSTERDAM, Bd. 48, Nr. 1-4, 1. November 1997 (1997-11-01), Seiten 123-130, XP004111841 ISSN: 0927-0248
- GUILLEN C ET AL: "CATHODIC ELECTRODEPOSITION OF CUINSE2 THIN FILMS" THIN SOLID FILMS,CH,ELSEVIER-SEQUOIA S.A. LAUSANNE, Bd. 195, Nr. 1 / 02, 1991, Seiten 137-146, XP000177084 ISSN: 0040-6090

## Beschreibung

Die Erfindung betrifft eine Diodenstruktur, insbesondere zur Verwendung für Dünnfilmsolarzellen.

Dünnfilmsolarzellen auf der Basis polykristalliner Halbleiter bieten gute Chancen, die Kosten zur Herstellung von stabilen und hocheffizienten Solarmodulen deutlich zu senken. Dünnschichtsolarzellen auf der Basis von Chalkopyrithalbleitern weisen unter allen Dünnschichtsolarzellen bisher die höchsten Wirkungsgrade auf und gelten als interessanter Kandidat für künftige Solarstrom- oder Photovoltaik-Anlagen mit geringeren Kosten. Unter Chalkopyritverbindungen fallen hierbei Verbindungen der Gruppe Cu(InGa)(SSe)₂ und insbesondere Kupfer-Indium-Diselenid (CuInSe₂).

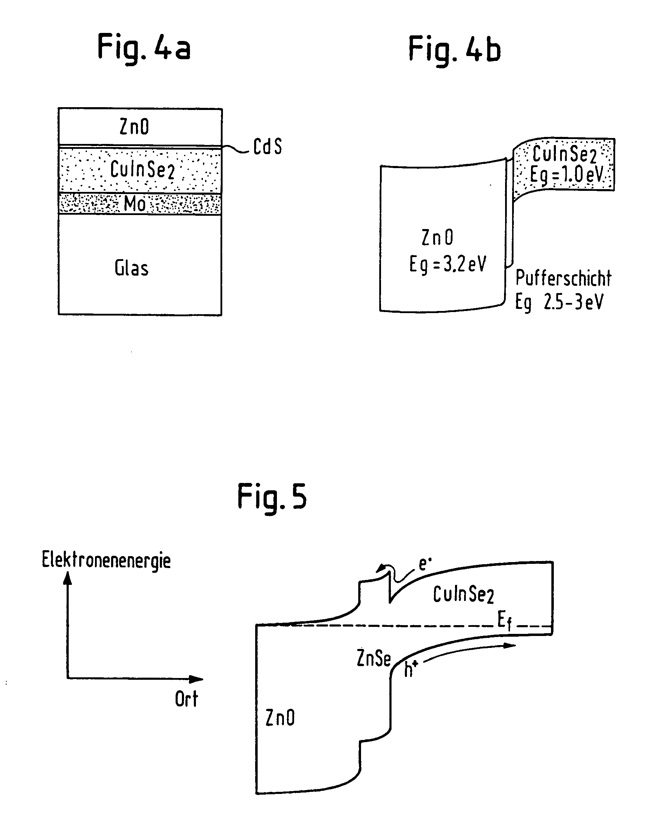

Einen typischen Schichtaufbau einer Chalkopyritzelle zeigt Fig. 4a. Auf dem p-leitenden Chalkopyrithalbleiter bildet eine CdS-Schicht einen Heteroübergang, dessen elektrisches Feld die Ladungsträgertrennung ermöglicht. Den Vorderseitenkontakt obenauf bildet eine ZnO-Schicht und den Rückseitenkontakt eine Molybdän-Schicht auf einem isolierenden Substrat wie z.B. Glas.

In Fig. 4b ist das entsprechende Banddiagramm zu der Struktur in Fig. 4a dargestellt. Hierbei ist zu erkennen, dass die ZnO-Fensterschicht einen wesentlich größeren Bandabstand aufweist. Damit wird verhindert, dass photogenerierte Ladungsträger direkt an der Solarzellenoberfläche absorbiert werden und - aufgrund der hohen Defektdichte - dort sofort wieder rekombinieren. Die Heterostruktur führt daher zu wesentlich größeren Eindringtiefen und höherer Photostromausbeute. Allerdings müssen der p-leitende Absorber und die n-leitende Fensterschicht eine gute strukturelle und elektronische Anpassung aufweisen.

Bekannte und in der Fertigung erprobte Fensterschichten basieren auf dotierten Metalloxiden wie z.B. ZnO, SnO₂ oder InSnO₂ (ITO), verallgemeinernd als Transparent Conductive Oxide (TCO) bezeichnet. Die bekannten TCO-Schichten besitzen allerdings keine gute Anpassung hinsichtlich Gitterkonstante oder Elektronenaffinität an die Chalkopyrithalbleiter. Deshalb führte die direkte Kombination dieser Fensterschichten mit Chalkopyritabsorbern bislang noch zu keinen hohen und reproduzierbaren Solarzellenwirkungsgraden.

Zur verbesserten Anpassung von TCO und Absorber werden üblicherweise dünne, d.h. nur ca. 50 nm dicke Pufferschichten zwischen Absorber- und Fensterschicht eingefügt. Die beste elektronische Qualität und die höchsten Wirkungsgrade zeigt eine Diodenkonfiguration bestehend aus Chalkopyritabsorber, CdS-Pufferschicht und ZnO-Frontelektrode. Mit diesem Solarzellenaufbau können die mit Abstand höchsten Wirkungsgrade unter allen Dünnschichtsolarzellen (bis zu 18.8%) erreicht werden. Darüber hinaus weist dieser Solarzellenaufbau die größte Prozeßtoleranz hinsichtlich der Schichtdicke und damit die höchsten Ausbeuten in der Fertigung auf.

Die bislang erfolgreichsten Chalkopyritsolarzellen enthalten allerdings - bedingt durch die CdS-Pufferschicht - Schwermetalle, die erhöhte Aufwendungen in Fertigung und Entsorgung hervorrufen.

Aus Jap. Journ. Appl. Phys., Band 35, Part I, No. 6A (Juni 1996), Seiten 3334-3342, ist eine Dünnfilmsolarzelle bekannt, die eine Diodenstruktur nTiO₂/pCuInSe₂ aufweist. Aufgabe der Erfindung ist es daher, eine Diodenstruktur für Dünnfilmsolarzellen zu schaffen, die einen möglichst einfachen Aufbau einer Dünnfilmsolarzelle bei hohem Wirkungsgrad und Verwendung möglichst umweltfreundlicher Materialien ermöglicht.

Diese Aufgabe wird durch die Merkmale der Patentansprüche 1-8 gelöst. Erfindungsgemäß läßt sich mit einer derartigen Diodenstruktur eine Dünnfilmsolarzelle gemäß den Ansprüchen 9-16 aufbauen.

Die erfindungsgemäße Diodenstruktur weist eine p-leitende Schicht bestehend aus einer Chalkopyritverbindung und eine an die p-leitende Schicht angrenzende n-leitende Schicht bestehend aus einer Titan und Sauerstoff enthaltenden Verbindung auf. Es wurde herausgefunden, dass eine Titan und Sauerstoff enthaltende Verbindung als n-leitende Schicht eine gute Anpassung an eine p-leitende Schicht bestehend aus einer Chalkopyritverbindung ermöglicht. Insbesondere läßt sich auch eine gute Anpassung im Leitungsband erreichen, wodurch der Elektronenstromfluß verbessert wird.

Darüber hinaus besteht die Erfindung darin, dass die Diodenstruktur durch eine n-leitende Verstärkungsschicht einfach ergänzt wird, wodurch die Diodenstruktur in ihren Eigenschaften noch verbessert wird. Die n-leitende Verstärkungsschicht grenzt dabei an die von der p-leitenden Schicht abgewandten Seite der n-leitenden Schicht an und weist einen größeren Bandabstand als die n-leitende Schicht auf. Vorzugsweise besteht die n-leitende Verstärkungsschicht aus einem transparenten und leitfähigen Oxid, wie z.B. einem dotierten Metalloxid. Besonders günstig haben sich ZnO, SnO₂ oder InSnO₂ herausgestellt.

Aufgrund dieser einfachen Erweiterungsmöglichkeit durch eine n-leitende Verstärkungsschicht entsteht eine kadmiumfreie Fensterschicht, wobei in diesem Fall die n-leitende TiOₓ-Schicht als Pufferschicht zur Passivierung der Oberfläche des pn-Übergangs dient.

Nach einer bevorzugten Ausführungsform ist vorgesehen, dass die Chalkopyritverbindung ein I-III-VI-Halbleiter aus der Gruppe Cu(InGa)(SSe)₂) ist. Als besonders vorteilhaft hat es sich herausgestellt, Kupfer-Indium-Diselenid (CuInSe₂) zu verwenden.

Die Titan und Sauerstoff enthaltende Verbindung besteht vorzugsweise aus einer Verbindung aus der Gruppe TiOₓ mit 1,5 < x < 2. Ein Kriterium bei der Auswahl der Verbindung aus der Gruppe TiOₓ im Hinblick auf die verwendete Chalkopyritverbindung könnte darin bestehen, eine möglichst gute Anpassung im Leitungsband zu erreichen.

Demgegenüber sind bisher kadmiumfreie Puffer- oder Fensterschichten mit einer Chalkopyritverbindung als Absorberschicht bekannt, bei denen als Pufferschicht ZnSe oder ZnS verwendet werden. Die Nachteile dieser bekannten kadmiumfreien Pufferschichten zeigt das Banddiagramm gemäß Fig. 5. Es ist zu erkennen, dass die ZnSe-Pufferschicht zu einer Barriere im Leitungsband führt, die den Elektronenfluß vom Absorber in die Fensterschicht zumindest bei zu großen Dicken der Pufferschicht behindert. Eine Erklärung ist in der verhältnismäßig geringen Elektronenaffinität der Fensterschicht ZnSe im Verhältnis zu dem Chalkopyritabsorber zu sehen. Als Lösung dieses Problems wurden bisher relativ kleine Pufferschichtdicken bestehend aus ZnSe gewählt, durch die der Ladungsträgertransport über Tunnelprozesse unterstützt wird. Allerdings sind diese geringen Pufferschichtdicken in einer Großflächentechnologie schwer zu beherrschen und führen zu Problemen mit der Reproduzierbarkeit der elektrischen Kenngrößen der Solarzellen.

Von daher liefert die Erfindung nicht nur eine besonders einfache Diodenstruktur, sondern ermöglicht in Verbindung mit einer geeigneten n-leitenden Verstärkungsschicht auch einen kadmiumfreien Dünnschichtaufbau mit Wirkungsgraden, die bisher nur mit einer CdS-Schicht als Heteroübergang erreicht werden konnten.

Um mit der erfindungsgemäßen Diodenstruktur eine Dünnfilmsolarzelle aufbauen zu können, ist es aufgrund der zu geringen Leitfähigkeit der p-leitenden Chalkopyritschicht erforderlich, dass die der n-leitenden Schicht abgewandte Seite der p-leitenden Chalkopyritschicht an einen Stromsammelkontakt angrenzt, der insbesondere als ganzflächige Rückelektrode ausgebildet sein kann.

Es bestehen nunmehr zwei Möglichkeiten des Designs, nämlich ein Substrat-Design und ein Superstrate-Design. Das Substrat-Design ist dadurch gekennzeichnet, dass die Rückelektrode an ein Substrat angrenzt, das der Lichteintrittsseite abgewandt ist. Demgegenüber ist das Superstrate-Design dadurch gekennzeichnet, dass die n-leitende Schicht an ein Substrat angrenzt, dass der Lichteintrittsseite zugewandt ist. Die Superstratekonfiguration ist zwar problematischer in der Herstellung, ist allerdings in der Regel vorzuziehen, da hier die Zelle auf der Lichteintrittsseite bereits gegen Umwelteinflüsse geschützt ist.

Ein Kriterium für die Auswahl der Schichtdicke der n-leitenden Schicht besteht darin, die Schichtdicke möglichst zu minimieren, um damit TiOₓ-Elektroden möglichst wirtschaftlich herstellen zu können. Hierbei ist insbesondere zu berücksichtigen, dass in Abhängigkeit der Beleuchtungsbedingungen sich unterschiedliche Anforderungen an den Flächenwiderstand der n-leitenden Schicht ergeben können. Beispielsweise ergeben sich im Innenraumbereich schwächere Beleuchtungsbedingungen als im Außenbereich, so dass hier mit geringeren Flächenwiderständen gearbeitet werden kann, die eine entsprechend reduzierte Schichtdicke der TiOₓ-Elektrode ermöglichen. Je nach Anwendungsfall haben sich Flächenwiderstände zwischen 1 Ω und 50 Ω als günstig herausgestellt, wobei der Flächenwiderstand durch das Verhältnis von spezifischem Widerstand und Schichtdicke definiert ist.

Ausgehend von einer erfindungsgemäßen Diodenstruktur, die mit einer n-leitenden Verstärkungsschicht verstärkt ist, ergeben sich auch bei einem derartigen Sperrschichtaufbau wiederum zwei Möglichkeiten des Designs. Das Substrat-Design ist wiederum dadurch gekennzeichnet, dass die Rückelektrode an ein Substrat angrenzt, das der Lichteintrittsseite abgewandt ist. Demgegenüber ist das Superstrate-Design in diesem Fall dadurch gekennzeichnet, dass die n-leitende Verstärkungsschicht an ein Substrat angrenzt, das der Lichteintrittsseite zugewandt ist.

In allen Fällen hat es sich bewährt, dass die Rückelektrode aus Molybdän besteht und dass das Substrat aus Glas besteht.

Im folgenden wird die Erfindung anhand verschiedener Ausführungsbeispiele mit Bezug auf die beiliegenden Zeichnungen näher erläutert. Es zeigen:
- Fig. 1:: Einen Schichtaufbau einer Dünnfilmsolarzelle mit einer Sperrschicht nach dem Substrat-Design (Fig. 1a) und dem Superstrate-Design (Fig. 1b),
- Fig. 2:: den Schichtaufbau mit einer erfindungsgemäßen Sperrschicht, die eine zusätzliche Verstärkungsschicht aufweist, nach dem Substrat-Design (Fig. 2a) und dem Superstrate-Design (Fig. 2b),
- Fig. 3:: ein Banddiagramm einer erfindungsgemäßen Sperrschicht mit einer zusätzlichen Verstärkungsschicht,
- Fig. 4:: Aufbau und Banddiagramm einer herkömmlichen CIS-Dünnfilmsolarzelle mit einer dünnen CdS-Pufferschicht und
- Fig. 5:: ein Banddiagramm einer herkömmlichen kadmiumfreien CIS-Dünnfilmsolarzelle mit einer ZnSe-Pufferschicht.

Auf die Figuren 4 und 5 wurde bereits in der Beschreibungseinleitung Bezug genommen.

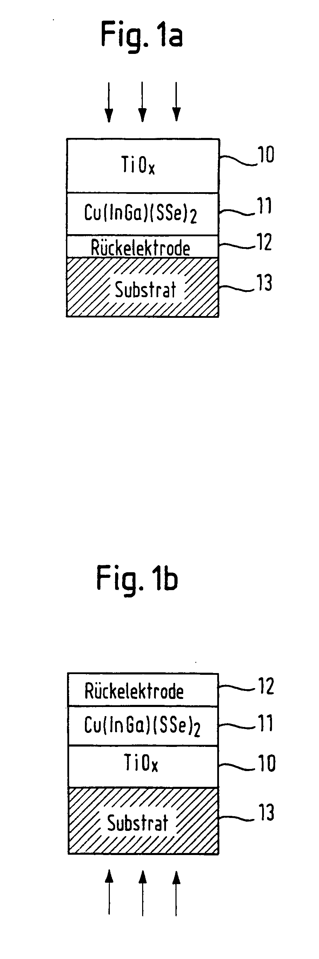

Fig. 1 zeigt den Schichtaufbau einer Dünnfilmsolarzelle mit einer Sperrschicht, die eine p-leitende Schicht bestehend aus einer Chalkopyritverbindung und eine an die p-leitende Schicht angrenzende n-leitende Schicht bestehend aus einer Titan und Sauerstoff enthaltenden Verbindung aufweist. Grundsätzlich sind zwei wesentliche Kategorien des Schichtaufbaus zu unterscheiden, nämlich einmal Abscheidung der TiOₓ-Schicht auf einer bestehenden Chalkopyritschicht (Substrat-Design) und zum anderen Abscheidung der Chalkopyritschicht auf einer bestehenden TiOₓ-Oberfläche (Superstrate-Design). Zahlreiche Abscheidemethoden für TiOₓ-Dünnschichten sind aus der Literatur bekannt und im Prinzip alle für die erfindungsgemäße Anwendung einsetzbar. Einschränkungen bestehen allerdings bei der zulässigen Maximaltemperatur zur Abscheidung der TiOₓ-Schicht, die sich aus den Temperaturbegrenzungen der unterliegenden Schichten ergibt. Andernfalls kommt es zu unerwünschten Interdiffusionseffekten, Materialdegradation und/oder Substratverwerfungen. Bevorzugte Abscheidetemperaturen für das Substrat-Design liegen daher bei unter 400°C.

Fig. 1a zeigt ein Substrat 13, auf dem eine Rückelektrode 12 bestehend aus beispielsweise Molybdän aufgebracht ist. Auf die Rückelektrode 12 werden sodann nacheinander eine Chalkopyritschicht 11 und eine Titanoxidschicht 10 aufgebracht. Hierbei handelt es sich um ein Substrat-Design, so dass die Titanoxidschicht 10 der Lichteintrittsseite zugewandt ist.

Fig. 1b zeigt einen analogen Schichtaufbau wie Fig. 1a gemäß dem Superstrate-Design. Demnach ist auf das Substrat 13 eine Titan-Oxidschicht aufgebracht, woraufhin die Chalkopyritschicht 11 und die Rückelektrode 12 folgen. Der Lichteinfall erfolgt dementsprechend von der Substratseite her.

Bei dem Schichtaufbau gemäß den Figuren 1a und 1b muß besonderes Augenmerk auf die erzielbare Leitfähigkeit der TiOₓ-Elektrode in Abhängigkeit von der gewünschten Anwendung gerichtet werden. Beispielsweise muß für einen Einsatz als terrestrische Solarzelle ein Flächenwiderstand der Frontelektrode von unter 20 Ω erzielt werden. Bei einer üblichen Modulgröße ist dies erfahrungsgemäß bei einer TiOₓ-Leitfähigkeit von über 100 (Ωcm)⁻¹ erfüllbar. Dabei reduzieren sich die Anforderungen an die Leitfähigkeit der Frontelektrode unter schwächeren Beleuchtungsbedingungen (z.B. im Innenraumbereich), so dass hier gegebenenfalls auch mit geringeren Flächenwiderständen gearbeitet werden kann.

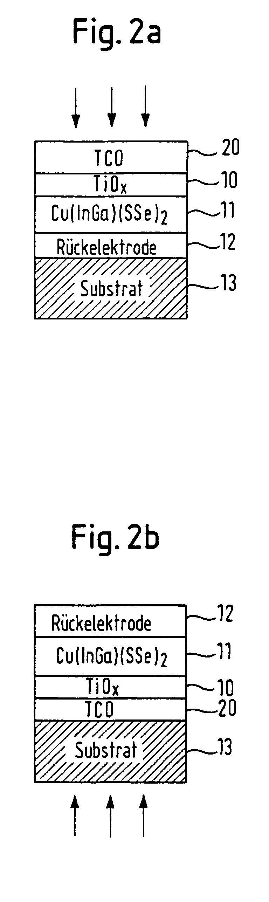

Sollte allerdings unter Normalbedingungen die Frontelektrode eine Leitfähigkeit von weniger als 100 (Ωcm)⁻¹ aufweisen, so sollte die Frontelektrode vorzugsweise durch geeignete transparente Frontelektrodenschichten verstärkt werden. Einen derartigen Aufbau mit einer n-leitenden Verstärkungsschicht gemäß der Erfindung zeigt Fig. 2. Als Verstärkungsschichten bieten sich TCO-Schichten (TCO für Transparent Conductive Oxide) an, wie z.B. ZnO, SnO₂, InSnO₂ (ITO) oder andere dotierte Metalloxide. Der Schichtaufbau gemäß Fig. 2a unterscheidet sich somit gegenüber dem Schichtaufbau gemäß Fig. 1a dadurch, dass auf die Titanoxidschicht 10 eine zusätzliche TCO-Schicht 20 aufgebracht ist. Da es sich hier um ein Substrat-Design handelt, erfolgt der Lichteinfall über die zusätzlich aufgebrachte TCO-Schicht.

Um demgegenüber eine Verstärkungsschicht bei dem Superstrate-Design gemäß Fig. 1b einzuführen, wird gemäß Fig. 2b auf das Substrat zunächst die TCO-Schicht aufgebracht, bevor der aus Fig. 1b bekannte Schichtaufbau folgt. Der Lichteinfall erfolgt wiederum wie in Fig. 1b über das Substrat 13.

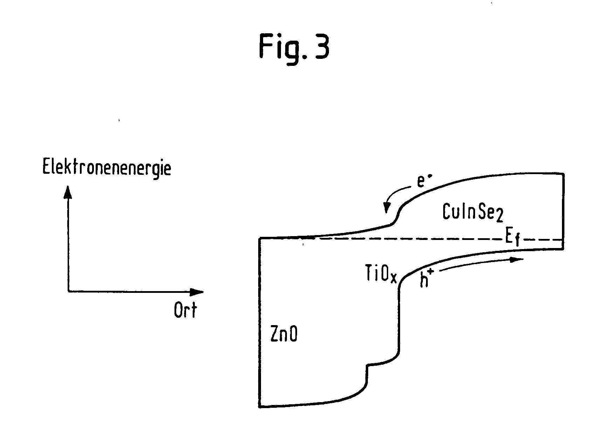

Fig. 3 zeigt ein Banddiagramm einer erfindungsgemäßen Sperrschicht mit dem Schichtaufbau gemäß Fig. 2. An die Chalkopyritschicht schließt sich eine TiOₓ-Schicht an, die durch eine ZnO-Schicht verstärkt wird. Die ZnO-Schicht weist einen noch größeren Bandabstand als die TiOx-Schicht auf, wodurch sichergestellt ist, dass photogenerierte Ladungsträger nicht direkt an der Solarzellenoberfläche absorbiert werden. Die Titanoxidschicht hat in diesem Fall die Aufgabe einer Pufferschicht zwischen der ZnO-Schicht und der Chalkopyritschicht. Ein Vergleich mit der bereits beschriebenen Fig. 5 zeigt den besonderen Vorteil des erfindungsgemäßen Sperrschichtaufbaus: Bedingt durch die höhere Elektronenaffinität von TiOₓ (ca. 4,3 eV) im Vergleich zu der bisher verwendeten Pufferschicht ZnSe gemäß Fig. 5 wird die energetische Barriere im Leitungsband erheblich reduziert und der Elektronenstromfluß dadurch verbessert. Es ist keine thermische Aktivierung oder tunnelunterstützter Transport für den Elektronenstrom vom Absorber in Richtung Frontelektrode mehr erforderlich.

## Patentansprüche

1. Diodenstruktur, insbesondere für Dünnfilmsolarzellen,
mit einer p-leitenden Schicht bestehend aus einer Chalkopyritverbindung, und
mit einer an die p-leitende Schicht angrenzenden n-leitenden Schicht bestehend aus einer Titan und Sauerstoff enthaltenen Verbindung,
wobei die von der p-leitenden Schicht abgewandte Seite der n-leitenden Schicht an eine n-leitende Verstärkungsschicht angrenzt, die einen größeren Bandabstand als die n-leitende Schicht aufweist.

2. Diodenstruktur nach Anspruch 1, **dadurch gekennzeichnet, dass** die Chalkopyritverbindung ein I-III-VI₂-Halbleiter aus der Gruppe Cu(InGa)(SSe)₂) ist.

3. Diodenstruktur nach Anspruch 2, **dadurch gekennzeichnet, dass** die Chalkopyritverbindung aus CuInSe₂ (CIS) besteht.

4. Diodenstruktur nach einem der Ansprüche 1-3, **dadurch gekennzeichnet, dass** die Titan und Sauerstoff enthaltende Verbindung aus der Gruppe TiOₓ mit 1,5 < x < 2 ausgewählt ist.

5. Diodenstruktur nach Anspruch 4, **dadurch gekennzeichnet, dass** die Titan und Sauerstoff enthaltende Verbindung aus der Gruppe TiOₓ im Hinblick auf die verwendete Chalkopyritverbindung derart ausgewählt wird, dass eine möglichst gute Anpassung im Leitungsband gegeben ist.

6. Diodenstruktur nach einem der Ansprüche 1 bis 5, **dadurch gekennzeichnet, dass** die n-leitende Verstärkungsschicht aus einem transparenten und leitfähigen Oxid besteht.

7. Diodenstruktur nach Anspruch 6, **dadurch gekennzeichnet, dass** das transparente und leitfähige Oxid auf einem dotierten Metalloxid basiert.

8. Diodenstruktur nach Anspruch 7, **dadurch gekennzeichnet, dass** das transparente und leitfähige Oxid aus ZnO oder aus SnO₂ oder aus InSnO₂, besteht.

9. Dünnfilmsolarzelle mit einer Diodenstruktur nach einem der Ansprüche 1-8.

10. Dünnfilmsolarzelle nach Anspruch 9, **dadurch gekennzeichnet, dass** die der n-leitenden Schicht abgewandte Seite der p-leitenden Schicht an einen Stromsammelkontakt angrenzt.

11. Dünnfilmsolarzelle nach Anspruch 10, **dadurch gekennzeichnet, dass** der Stromsammelkontakt als ganzflächige Rückelektrode ausgebildet ist.

12. Dünnfilmsolarzelle nach einem der Ansprüche 10 oder 11 **dadurch gekennzeichnet, dass** der Stromsammelkontakt an ein Substrat angrenzt, das der Lichteintrittsseite abgewandt ist (Substrat-Design).

13. Dünnfilmsolarzelle nach einem der Ansprüche 10 oder 11 **dadurch gekennzeichnet, dass** die n-leitende Verstärkungsschicht an ein Substrat angrenzt, das der Lichteintrittsseite zugewandt ist (Superstrate-Design).

14. Dünnfilmsolarzelle nach einem der Ansprüche 9 bis 13, **dadurch gekennzeichnet, dass** die Schichtdicke der n-leitenden Schicht unter den gegebenen Randbedingungen minimiert wird.

15. Dünnfilmsolarzelle nach einem der Ansprüche 10 bis 14, **dadurch gekennzeichnet, dass** der Stromsammelkontakt aus Molybdän besteht.

16. Dünnfilmsolarzelle nach einem der Ansprüche 12 bis 15, **dadurch gekennzeichnet, dass** das Substrat aus Glas besteht.

## Claims

1. Diode structure, in particular for thin-film solar cells with a p-type layer
consisting of a chalcopyrite compound, and
with a n-type layer adjoining the p-type layer and consisting of a titanium and oxygen containing compound,
the side of the n-type layer facing away from the p-type layer adjoining a n-type boosting layer comprising a greater band gap than the n-type layer.

2. Diode structure according to claim 1, **characterised in that** the chalcopyrite compound is a I-III-VI₂ semiconductor of the group Cu(InGa)(SSe)₂).

3. Diode structure according to claim 2, **characterised in that** the chalcopyrite compound consists of CuInSe₂ (CIS).

4. Diode structure according to one of claims 1 to 3, **characterised in that** the compound containing titanium and oxygen is chosen from the group TiOₓ with 1,5 < x < 2.

5. Diode structure according to claim 4, **characterised in that** the compound containing titanium and oxygen is chosen from the group TiOₓ with respect to the chalcopyrite compound in such a way that the best possible adaptation in the conduction band is achieved.

6. Diode structure according to one of claims 1 to 5, **characterised in that** the n-type boosting layer consists of a transparent and conductible oxide.

7. Diode structure according to claim 6, **characterised in that** the transparent and conductible oxide is based on a doped metallic oxide.

8. Diode structure according to claim 8, **characterised in that** the transparent and conductible oxide consists of ZnO or SnO₂ or InSnO₂.

9. Thin-film solar cell with a diode structure according to one of claims 1 to 8.

10. Thin-film solar cell according to claim 9, **characterised in that** the side of the p-type layer facing away from the n-type layer adjoins a collecting current contact.

11. Thin-film solar cell according to claim 10, **characterised in that** the collecting current contact is formed as an entire surface back electrode.

12. Thin-film solar cell according to claim 10 or 11, **characterised in that** the collecting current contact adjoins a substrate which faces away from the side of light penetration (substrate design).

13. Thin-film solar cell according to claim 10 or 11, **characterised in that** the n-type boosting layer adjoins a substrate facing the side of light penetration (superstrate design).

14. Thin-film solar cell according to one of claims 9 to 13, **characterised in that** the layer thickness of the n-type layer is minimised under the given boundary conditions.

15. Thin-film solar cell according to one of claims 10 to 14, **characterised in that** the collecting current contact consists of molybdenum.

16. Thin-film solar cell according to one of claims 12 to 15, **characterised in that** the substrate consists of glass.

## Revendications

1. Structure à diodes, en particulier pour cellules solaires à couche mince, comprenant :
une couche de conductivité de type p constituée d'un composé de chalcopyrite, et
une couche de conductivité de type n adjacente à la couche à conductivité de type p, constituée d'un composé contenant du titane et de l'oxygène,
dans laquelle la face de la couche de conductivité de type n opposée à la couche de conductivité de type p jouxte une couche de hausse de conductivité de type n, qui présente une largeur de bande interdite plus grande que celle de la couche de conductivité de type n.

2. Structure à diodes selon la revendication 1, **caractérisée en ce que** le composé de chalcopyrite est un semi-conducteur I-III-VI₂ du groupe Cu(InGa)(SSe)₂).

3. Structure à diodes selon la revendication 2, **caractérisée en ce que** le composé de chalcopyrite est constitué de CuInSe₂ (CIS).

4. Structure à diodes selon l'une quelconque des revendications 1 à 3, **caractérisée en ce que** le composé contenant du titane et de l'oxygène est choisi dans le groupe des composés TiOₓ où 1,5 < x < 2.

5. Structure à diodes selon la revendication 4, **caractérisée en ce que** le composé contenant du titane et de l'oxygène est choisi dans le groupe des composés TiOₓ, eu égard au composé de chalcopyrite utilisé, de manière à disposer de la meilleure adaptation possible dans la bande de conduction.

6. Structure à diodes selon l'une quelconque des revendications 1 à 5, **caractérisée en ce que** la couche de hausse de conductivité de type n est constituée d'un oxyde transparent et conducteur.

7. Structure à diodes selon la revendication 6, **caractérisée en ce que** l'oxyde transparent et conducteur est un oxyde métallique dopé.

8. Structure à diodes selon la revendication 7, **caractérisée en ce que** l'oxyde transparent et conducteur est constitué de ZnO, de SnO₂ ou de InSnO₂.

9. Cellule solaire à couche mince comprenant une structure à diodes selon l'une quelconque des revendications 1 à 8.

10. Cellule solaire à couche mince selon la revendication 9, **caractérisée en ce que** la face de la couche de conductivité de type p opposée à la couche de conductivité de type n est adjacente à un contact collecteur de courant.

11. Cellule solaire à couche mince selon la revendication 10, **caractérisée en ce que** le contact collecteur de courant se présente sous la forme d'une électrode de renvoi à pleine surface.

12. Cellule solaire à couche mince selon l'une quelconque des revendications 10 ou 11, **caractérisée en ce que** le contact collecteur de courant est adjacent à un substrat qui est opposé à la face d'entrée de la lumière (configuration de substrat).

13. Cellule solaire à couche mince selon l'une quelconque des revendications 10 ou 11, **caractérisée en ce que** la couche de hausse de conductivité de type n est adjacente à un substrat qui est tourné vers la face d'entrée de la lumière (configuration de superstrate).

14. Cellule solaire à couche mince selon l'une quelconque des revendications 9 à 13, **caractérisée en ce que** l'épaisseur de la couche de conductivité de type n est minimisée dans les conditions marginales données.

15. Cellule solaire à couche mince selon l'une quelconque des revendications 10 à 14, **caractérisée en ce que** le contact collecteur de courant est constitué de molybdène.

16. Cellule solaire à couche mince selon l'une quelconque des revendications 12 à 15, **caractérisée en ce que** le substrat est constitué de verre.
